(19) Europäisches Patentamt European Patent Office Office européen des brevets

(11) **EP 4 764 541 A1**

(12) **EUROPEAN PATENT APPLICATION**
published in accordance with Art. 153(4) EPC

(43) Date of publication:
**24.06.2026 Bulletin 2026/26**

(21) Application number: **24910933.1**

(22) Date of filing: **19.12.2024**

(51) International Patent Classification (IPC):
**G01R 31/392** (2019.01)   **G01R 31/396** (2019.01)
**G01R 31/36** (2020.01)   **G01R 31/367** (2019.01)

(52) Cooperative Patent Classification (CPC):
**G01R 31/36; G01R 31/367; G01R 31/392;**
**G01R 31/396**

(86) International application number:
**PCT/CN2024/140668**

(87) International publication number:
**WO 2025/140004 (03.07.2025 Gazette 2025/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **28.12.2023  CN 202311827281**

(71) Applicant: **VOYAH Automotive Technology Co.,**
**Ltd.**
**Wuhan, Hubei 430109 (CN)**

(72) Inventors:
• **WANG, Yongshi**
  **Wuhan, Hubei 430050 (CN)**
• **XIE, Hui**
  **Wuhan, Hubei 430050 (CN)**

• **LIU, Zhenyong**
  **Wuhan, Hubei 430050 (CN)**
• **ZHU, Jinxin**
  **Wuhan, Hubei 430050 (CN)**
• **HUANG, Min**
  **Wuhan, Hubei 430050 (CN)**
• **WANG, Junjun**
  **Wuhan, Hubei 430050 (CN)**
• **HUA, Zhen**
  **Wuhan, Hubei 430050 (CN)**
• **KANG, Chuanchao**
  **Wuhan, Hubei 430050 (CN)**
• **NIE, Maotao**
  **Wuhan, Hubei 430050 (CN)**
• **ZHANG, Zhenyan**
  **Wuhan, Hubei 430050 (CN)**

(74) Representative: **Bandpay & Greuter**
**11 rue Christophe Colomb**
**75008 Paris (FR)**

(54) **BATTERY THERMAL RUNAWAY RISK DIAGNOSIS METHOD AND APPARATUS**

(57) A battery thermal runaway risk diagnosis method, including: at each of first acquisition time points in a target cycle, acquiring a first voltage of each cell of a battery; calculating an average of first voltages of all cells at each of the first acquisition time points to obtain a voltage average; determining a respective first difference between the first voltage of each cell at each of the first acquisition time points and the voltage average; calculating an average of all first differences corresponding to all of the first acquisition time points for each cell to obtain a difference average; and if the first average of the cell is greater than the third average, and the second average is less than the third average, determining that a phenomenon of high voltage during charging and low voltage during discharging occurs to the battery.

At each of first acquisition time points in a target cycle, acquiring a first voltage of each cell of a battery — S1

Calculating an average of first voltages of all cells at each of the first acquisition time points to obtain a voltage average; determining a respective first difference between the first voltage of each cell at each of the first acquisition time points and the voltage average; calculating an average of all first differences corresponding to all of the first acquisition time points for each cell to obtain a difference average — S2

If the first average of the cell is greater than the third average, and the second average is less than the third average, determining that a phenomenon of high voltage during charging and low voltage during discharging occurs to the battery — S3

FIG. 1

EP 4 764 541 A1

## Description

### CROSS-REFERENCE TO RELATED APPLICATION

This application claims priority to Chinese patent application No. 202311827281.3, filed with the China National Intellectual Property Administration on December 28, 2023, which is hereby incorporated by reference in its entirety.

### TECHNICAL FIELD

The present disclosure relates to the field of battery technology and, in particular, to a battery thermal runaway risk diagnosis method and apparatus.

### BACKGROUND

With the increasing market penetration of new energy vehicles, concerns about the safety, cruising endurance, and energy consumption of new energy vehicles have become prominent. Among these, battery thermal runaway is the most significant issue affecting the safety of new energy vehicles. Causes of battery thermal runaway include the impact of by-products generated during battery usage (such as during charge-discharge cycles) on a battery. For example, when a by-product is lithium plating, it affects the electrochemical performance of the battery, leading to abnormalities such as increased internal resistance of a cell. The cell with the increased internal resistance often exhibits higher voltage during a charging process and lower voltage during a discharging process, that is, a phenomenon of "high voltage during charging and low voltage during discharging" occurs.

In related technologies, through battery thermal runaway cases, it is found that a significant proportion of batteries exhibit the phenomenon of "high voltage during charging and low voltage during discharging" before battery thermal runaway occurs. Therefore, timely detection of the phenomenon of "high voltage during charging and low voltage during discharging" of a battery is crucial for early identification of thermal runaway risks for the battery. Thus, how to monitor the phenomenon of "high voltage during charging and low voltage during discharging" of a battery is of great importance.

### SUMMARY

By utilizing one or more embodiments of the present disclosure, a battery thermal runaway risk diagnosis method and apparatus are provided to address the technical problem of how to detect the phenomenon of "high voltage during charging and low voltage during discharging" of a battery.

According to a first aspect of the present disclosure, a battery thermal runaway risk diagnosis method is provided, which may include: at each of first acquisition time points in a target cycle, acquiring a first voltage of each cell of a battery; where the target cycle includes a charging cycle, a discharging cycle, and a resting cycle; calculating an average of first voltages of all cells at each of the first acquisition time points to obtain a voltage average; determining a respective first difference between the first voltage of each cell at each of the first acquisition time points and the voltage average; calculating an average of all first differences corresponding to all of the first acquisition time points for each cell to obtain a difference average, where the difference average corresponding to the charging cycle is a first average, the difference average corresponding to the discharging cycle is a second average, the difference average corresponding to the resting cycle is a third average; and if the first average of the cell is greater than the third average, and the second average is less than the third average, determining that a phenomenon of high voltage during charging and low voltage during discharging occurs to the battery.

According to a second aspect of the present disclosure, a battery thermal runaway risk diagnosis apparatus is provided, which may include: an acquisition module, configured to acquire a first voltage of each cell of a battery at each of first acquisition time points in a target cycle; the target cycle including a charging cycle, a discharging cycle, and a resting cycle; a calculation module, configured to: calculate an average of first voltages of all cells at each of the first acquisition time points to obtain a voltage average; calculate an average of all first differences corresponding to all of the first acquisition time points for each cell to obtain a difference average; where the difference average corresponding to the charging cycle is a first average, the difference average corresponding to the discharging cycle is a second average, the difference average corresponding to the resting cycle is a third average; and a judgment module, configured to, if the first average of the cell is greater than the third average and the second average is less than the third average, determine that a phenomenon of high voltage during charging and low voltage during discharging occurs to the battery.

According to a third aspect of the present disclosure, an electronic device is provided, which may include a memory, a processor, and a computer program stored on the memory and executable on the processor, where when the processor executes the computer program, the aforementioned battery thermal runaway risk diagnosis method can be implemented.

According to a fourth aspect of the present disclosure, a computer-readable storage medium is provided, where the computer-readable storage medium stores a computer program, and when the computer program is executed by a processor, the aforementioned battery thermal runaway risk diagnosis method can be implemented.

## BRIEF DESCRIPTION OF DRAWINGS

To more clearly illustrate the technical solutions in the embodiments of the present disclosure, the drawings required for the description of the embodiments will be briefly introduced below. It is obvious that the drawings in the following description are only some embodiments of the present disclosure. For those skilled in the art, other drawings can be obtained from these drawings without creative effort.

FIG. 1 shows a flowchart of a battery thermal runaway risk diagnosis method according to some embodiments of the present disclosure.
FIG. 2 shows a schematic structural diagram of a battery thermal runaway risk diagnosis apparatus according to some embodiments of the present disclosure.

## DESCRIPTION OF EMBODIMENTS

The battery thermal runaway risk diagnosis method and apparatus according to some embodiments of the present disclosure solve the technical problem of how to detect the phenomenon of high voltage during charging and low voltage during discharging of a battery.

To better understand the technical solutions of the present disclosure, the following will describe the technical solutions of the present disclosure in detail with reference to the accompanying drawings and specific embodiments.

During battery usage, the inventors have found that if the phenomenon of high voltage during charging and low voltage during discharging occurs to a single cell of a battery, the voltage of the single cell will be higher during battery charging, and the voltage of the single cell will be lower during battery discharging. Additionally, the internal resistance of the single cell will continue to increase, gradually becoming a cell with the highest voltage during battery charging and the lowest voltage during battery discharging. Such a cell will severely impact the use performance and lifespan of the battery.

Based on the above problem, in a battery thermal runaway risk diagnosis method according to some embodiments of the present disclosure, at each of first acquisition time points within a preset acquisition period, by acquiring a first voltage of each cell of a battery during a target cycle, and analyzing and calculating voltage changes of the cell during target cycles based on acquired first voltages; if a first average corresponding to a certain cell is greater than a third average, a voltage of such cell during a charging cycle is higher than that during a resting cycle; if a second average corresponding to such cell is less than the third average, a voltage of such cell during a discharging cycle is lower than that during the resting cycle; that is, such cell exhibits higher voltage during the battery charging process and lower voltage during the battery discharging process, indicating that the phenomenon of high voltage during charging and low voltage during discharging occurs to such cell; such cell may be taken as a risk cell of the battery, thereby achieving the detection of the phenomenon of high voltage during charging and low voltage during discharging of the battery.

Below, specific embodiments will be used to describe the technical solutions of the present disclosure and how these solutions address the aforementioned technical problems. The following specific embodiments can be combined with each other, and for the same or similar concepts or processes, they may not be repeatedly described in some embodiments. The following will describe the embodiments of the present disclosure with reference to the accompanying drawings.

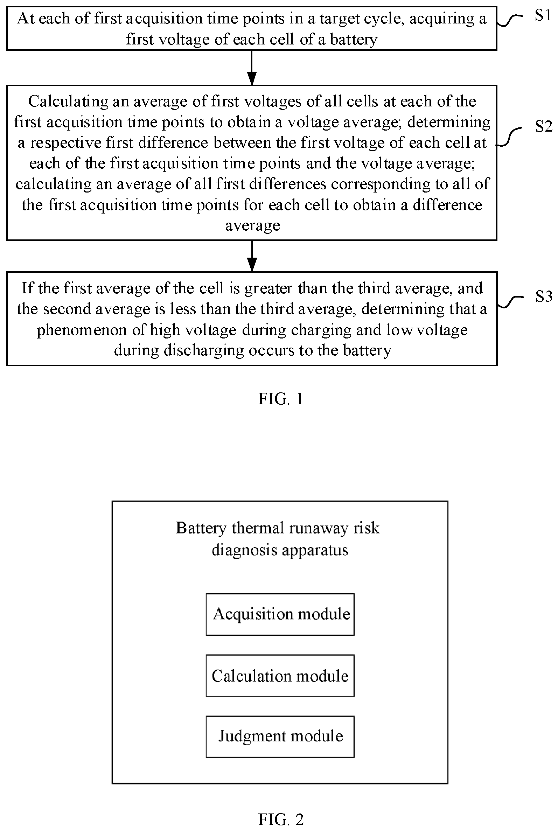

As shown in FIG. 1, which is a flowchart of a battery thermal runaway risk diagnosis method according to some embodiments of the present disclosure, the battery thermal runaway risk diagnosis method according to some embodiments of the present disclosure includes the following.

Step S1, at each of first acquisition time points in a target cycle, acquiring a first voltage of each cell of a battery.

In some embodiments, a first acquisition time point is determined based on a first acquisition interval within a preset acquisition period, and the target cycle of the battery may include a charging cycle, a discharging cycle, and a resting cycle.

In some embodiments, the preset acquisition period may be one natural day, and the first acquisition interval may be determined based on a first acquisition frequency. For example, the first acquisition interval may be 30 minutes or 20 seconds, which is not specifically limited here.

Step S2, calculating an average of first voltages of all cells at each of the first acquisition time points to obtain a voltage average; determining a respective first difference between the first voltage of each cell at each of the first acquisition time points and the voltage average; calculating an average of all first differences corresponding to all of the first acquisition time points for each cell to obtain a difference average.

In some embodiments, the difference average corresponding to the charging cycle is a first average, the difference average corresponding to the discharging cycle is a second average, the difference average corresponding to the resting cycle is a third average.

Step S3, if the first average of any cell is greater than the third average, and the second average is less than the third average, taking the cell as a risk cell, and determining that a phenomenon of high voltage during charging and low voltage during discharging occurs to the battery.

In some embodiments, the resting cycle satisfies a condition that the battery is not in a charging state, an absolute value of a total battery current is ≤0.05C, and this state lasts for more than 10 minutes. The first acquisition time point is determined based on an acquisition frequency of a cell voltage, i.e., a first acquisition frequency, and a first voltage is a cell voltage. Taking a charging cycle as an example, it is assumed that the battery has three cells (No. 1 to No. 3), and a cell voltage is acquired every second, with acquisition of the cell voltage for a total of three times. Then in Step S1, during the charging cycle, 3 cell voltages acquired at the 1st second, 3 cell voltages acquired at the 2nd second, and 3 cell voltages acquired at the 3rd second can be obtained. In Step S2, the following are calculated: an average of the 3 cell voltages for the 1st second, i.e., a first voltage average; a respective first difference between each of the cell voltages for the 1st second and the first voltage average (i.e., 3 first differences corresponding to the 1st second); a second voltage average of the 3 cell voltages for the 2nd second; a respective first difference between each of the cell voltages for the 2nd second and the second voltage average (i.e., 3 first differences corresponding to the 2nd second); an average of the 3 cell voltages for the 3rd second, a third voltage average; a respective first difference between each of the cell voltages for the 3rd second and the third voltage average (i.e., 3 first differences corresponding to the 3rd second), resulting in 3 first differences corresponding to the cell No. 1, 3 first differences corresponding to the cell No. 2, and 3 first differences corresponding to the cell No. 3 in total. Then, the following are calculated: an average of the 3 first differences corresponding to the cell No. 1, an average of the 3 first differences corresponding to the cell No. 2, and an average of the 3 first differences corresponding to the cell No. 3, resulting in 3 first averages corresponding to the 3 cells.

In Step S3, if the first average corresponding to a certain cell is greater than the third average, it can be considered that a voltage of the cell during a charging cycle is higher than a voltage during a resting cycle; if the second average corresponding to the cell is less than the third average, it can be considered that a voltage of the cell during a discharging cycle is lower than the voltage during the resting cycle. That is, the cell exhibits higher voltage during the battery charging process and lower voltage during the battery discharging process, indicating that a phenomenon of high voltage during charging and low voltage during discharging occurs to the cell and thus occurs to the battery.

In some embodiments, the cell with the first average greater than the third average and the second average less than the third average may be taken as a risk cell in the battery.

When the phenomenon of high voltage during charging and low voltage during discharging of a cell is not severe, a thermal runaway risk of the battery is relatively low, and there is no need to issue an abnormality warning for high voltage during charging and low voltage during discharging of the battery; however, when the phenomenon of high voltage during charging and low voltage during discharging of a cell is severe, a thermal runaway risk of the battery is relatively high, and an abnormality warning for high voltage during charging and low voltage during discharging of the battery needs to be issued. Therefore, after the Step S3, the battery thermal runaway risk diagnosis method may further include: calculating a respective difference between a first average and a second average corresponding to each risk cell, to obtain risk cells; taking each risk voltage difference as a severity parameter corresponding to the risk cell; the severity parameter being used to characterize a probability of the phenomenon of high voltage during charging and low voltage during discharging occurring to the risk cell; if the severity parameter is greater than a preset threshold, issuing an abnormality warning for high voltage during charging and low voltage during discharging of the battery.

In some embodiments, after the issuing an abnormality warning for high voltage during charging and low voltage during discharging of the battery, the method further includes: selecting a maximum value from severity parameters of all risk cells as a battery severity parameter corresponding to the acquisition period for the battery.

In some embodiments, detection on a battery system including multiple batteries may be further performed based on the aforementioned detection method for high voltage during charging and low voltage during discharging of the cell, with detection steps including the following.

S101, in each of acquisition sub-periods within a preset total acquisition period, determining a respective first battery severity parameter corresponding to each battery in a battery system.

Specifically, detection on each battery in the battery system may be performed based on the aforementioned detection operations for high voltage during charging and low voltage during discharging of a single battery. For example, the preset total acquisition period may be 100 days, and each of the acquisition sub-periods may be one day within the 100 days, i.e., determining first battery severity parameters of batteries in each day.

S102, sorting respective first battery severity parameters in all of the acquisition sub-periods for each battery in ascending order, to obtain a first sequence; acquiring a first battery severity parameter at a first target position in the first sequence as a second battery severity parameter of the battery; acquiring a first battery severity parameter at a second target position in the first sequence as a third battery severity parameter of the battery.

For example, the first target position may be the 50th position, and the second position may be the 25th position. That is, for each battery, its corresponding 100 first battery severity parameters are sorted in ascending order, a first battery severity parameter sorted at the 50th position is taken as the second battery severity parameter of the battery, and then a first battery severity parameter sorted at the 25th position is taken as the third severity parameter of the battery.

S103, determining a parameter threshold based on respective second battery severity parameters corresponding to all batteries of the battery system.

S 1031, sorting all of the second battery severity parameters in ascending order to obtain a second sequence; acquiring a second battery severity parameter at a third target position in the second sequence as a fourth battery severity parameter of the battery system, and acquiring a second battery severity parameter at a fourth target position in the second sequence as a fifth battery severity parameter of the battery system.

For example, the third target position may be the 75th position, and the fourth target position may be the 25th position. That is, second battery severity parameters for all batteries are sorted in ascending order, a fourth battery severity parameter V4 sorted at the 75th position is taken, and a fifth battery severity parameter V5 sorted at the 25th position is taken.

S1032, determining the parameter threshold based on a difference between the fourth battery severity parameter and the fifth battery severity parameter.

For example, the parameter threshold V0 may be calculated based on the following formula:

$$V0 = V4 + 1.5(V4 - V5).$$

S104, when a third battery severity parameter of any of the batteries is greater than the parameter threshold, issuing an abnormality warning for high voltage during charging and low voltage during discharging of the battery system.

In embodiments of the present disclosure, the inventors have found through battery thermal runaway cases that a significant proportion of single cells exhibit not only a phenomenon of "high voltage during charging and low voltage during discharging" but also a "voltage rebound" phenomenon before thermal runaway. In embodiments of the present disclosure, a terminal voltage of a battery is proportional to lithium-ion concentration in an outermost layer of a solid phase of the battery. During battery discharge, lithium ions in a solid phase of the positive electrode of the battery are consumed, and lithium ions in a liquid phase of the battery are needed to replenish the lithium ions in the solid phase of the positive electrode of the battery. If lithium-ion concentration in the liquid phase of the battery is relatively low at this time, lithium ions in the outermost layer of the solid phase of the positive electrode of the battery will not be replenished in time and the concentration will decrease, leading to a decrease in the terminal voltage of the battery, i.e., a voltage rebound phenomenon occurs to the battery at this time. The causes of the voltage rebound phenomenon can be further divided into the following situations.

(1) During the process of the battery transitioning from a discharging cycle to a resting cycle, lithium ions in the liquid phase of the battery are precipitated, leading to a decrease in lithium-ion concentration in the liquid phase. Under high-current discharge for the battery, lithium ions in the solid phase of the positive electrode of the battery are replenished slowly, and the terminal voltage of the battery is pulled down; the battery stops discharging and enters a resting state, the lithium-ion concentration in the outermost layer of the solid phase of the battery is gradually replenished, and the terminal voltage of the battery gradually rebounds and increases, i.e., a voltage rebound phenomenon occurs.

(2) Due to the continuous generation of by-products such as lithium plating during charge-discharge cycles of the battery, these by-products consume lithium ions in the liquid phase of the battery, leading to a decrease in lithium-ion concentration in the liquid phase of the battery. Under high-current discharge for the battery, lithium ions in the solid phase of the positive electrode of the battery are replenished slowly, and the terminal voltage of the battery is pulled down; the battery stops discharging and enters a resting state, the lithium-ion concentration in the outermost layer of the solid phase of the battery is gradually replenished, and the terminal voltage of the battery gradually rebounds and increases, i.e., a voltage rebound phenomenon occurs.

(3) The by-products generated during cycling use of the battery accumulate and block pores in a battery separator, leading to an increase in the resistance to the movement of lithium ions between positive and negative electrodes. Under high-current discharge for the battery, lithium ions in the solid phase of the positive electrode of the battery are replenished slowly, and the terminal voltage of the battery is pulled down; the battery stops discharging and enters a resting state, the lithium-ion concentration in the outermost layer of the solid phase of the battery is gradually replenished, and the terminal voltage of the battery gradually rebounds and increases, i.e., a voltage rebound phenomenon occurs.

Therefore, if a "voltage rebound" phenomenon of a battery can be discovered in a timely manner, it is more conducive to early discovery of a thermal runaway risk of the battery, i.e., the "voltage rebound" phenomenon of the battery needs to be monitored.

In an embodiment of the present disclosure, a voltage rebound detection may be performed on a battery after the battery enters from a discharging cycle into a resting cycle, with detection steps include the following.

S201, determining a target period within the resting cycle.

S2011, calculating a discharge rate and discharge capacity of the discharging cycle within last 3 minutes before a transition of the battery from the discharging cycle to the resting cycle.

S2012, when the discharge rate is greater than a first threshold and the discharge capacity is greater than a second threshold, taking the 20th minute after a start of the resting cycle as a start time point and an end time of the resting cycle as an end time point, and determining the target period based on the start time point and the end time point.

In some embodiments, a discharge rate and discharge capacity of the discharging cycle may be calculated within last 3 minutes before a transition of the battery from the discharging cycle to the resting cycle, i.e., within the last 3 minutes of the discharging cycle; when the discharge rate is greater than a first threshold and the discharge capacity is greater than a second threshold, the 20th minute after a start of the resting cycle is taken as a start time point and an end time of the resting cycle is taken as an end time point, and the target period is determined based on the start time point and the end time point.

For example, a transition process of the battery from the discharging cycle to the resting cycle may be obtained, and an average discharge rate and discharge capacity within the last 3 minutes of the discharging cycle may be calculated. When the discharge rate is greater than or equal to 0.2C (i.e., discharge of a battery capacity is completed in 5 hours) and the discharge capacity is greater than or equal to 3 times a feedback capacity (i.e., a charging capacity), the transition process meets a preset effective sampling scenario, and a sampling time of a battery voltage, i.e., a target period, is determined according to the resting cycle.

S202, at each of second acquisition time points within the target period, acquiring a second voltage of each cell of the battery.

In some embodiments, the second acquisition time point is an acquisition time point determined based on a second acquisition interval within the target period.

S203, acquiring a resting start voltage of each cell in the resting cycle.

In some embodiments, a second frame of data after entering the resting cycle is taken as starting data, and voltage values of all cells at this time, i.e., resting start voltages, are calculated.

S204, at each of the second acquisition time points, calculating a respective difference between the second voltage of each cell and a corresponding resting start voltage, to obtain a rebound voltage.

S205, calculating a respective average of rebound voltages at all of the second acquisition time points for each cell as an average rebound voltage; and based on the average rebound voltage of each cell, determining a respective rebound voltage threshold corresponding to the cell.

In some embodiments, 1.5 times an average rebound voltage may be taken as a corresponding rebound voltage threshold.

S206, when any of the rebound voltages corresponding to the cell is greater than a corresponding rebound voltage threshold, taking the cell as a rebound cell and issuing a voltage rebound warning for the battery.

S207, for each cell, calculating a respective difference between each corresponding rebound voltage and a corresponding average rebound voltage, to obtain a voltage rebound parameter, and taking a maximum value of all voltage rebound parameters of the cell as a cell rebound parameter of the cell.

S208, taking a maximum value of all cell rebound parameters as a battery rebound parameter of the battery. In some embodiments, after a cell voltage is acquired at a fixed frequency, i.e., a second acquisition frequency, each acquisition will obtain a frame of voltage data composed of all cell voltages, and a resting start voltage of a cell may be the 2nd frame of data after entering the resting cycle (considering that the battery may not have truly entered the resting cycle when the 1st frame of data is acquired). A preset duration may be 20 minutes, and the time difference between two adjacent second acquisition time points may be 30 minutes, i.e., after the battery enters the resting cycle for 20 minutes, a voltage data frame is acquired every 30 minutes until the last three frames of data before the end of the resting cycle, and the last data with an interval of less than 30 minutes is also taken as a valid data for calculation. Assuming that the battery has 3 cells and second voltages are acquired for a total of 3 times, 3 resting start voltages and 3 cell voltages (second voltages) at each of the second acquisition time points may be obtained, and 3 second differences (i.e., rebound voltages) corresponding to each of the second acquisition time points, and an average of the 3 second differences corresponding to the 3 second acquisition time points, i.e., an average rebound voltage, may be calculated. The maximum value of averages of all second differences is greater than zero, indicating that the voltage of the battery after 20 minutes of entering the resting cycle is higher than the voltage when it just enters the resting cycle, i.e., a voltage rebound phenomenon occurs.

In some embodiments, detection on a battery system including multiple batteries may further be performed based on the aforementioned detection method for voltage rebound, with detection steps including the following.

S301, in each of target sub-periods within a preset total target period, determining a respective first battery rebound parameter corresponding to each battery of the battery system.

Here, the total target period may be 100 days, and the target sub-period may be 1 day. The aforementioned rebound detection operations from S201 to S208 may be performed on each battery of the battery system each day within the 100 days, and first battery rebound parameters of all batteries each day may be determined.

S302, sorting respective first battery rebound parameters in all of the target sub-periods for each battery in ascending order, to obtain a third sequence; acquiring a first battery rebound parameter at a first target position in the third sequence as a second battery rebound parameter of the battery; acquiring a first battery rebound parameter at a second target position in the third sequence as a third battery rebound parameter of the battery.

In some embodiments, the first target position may be the 50th position, and the second target position may be the 25th position.

For example, first battery rebound parameters of 100 days corresponding to each battery may be sorted in ascending order, and a second battery rebound parameter at the 50th position and a third battery rebound parameter at the 25th position may be taken.

S303, determining a rebound parameter threshold based on respective second battery rebound parameters corresponding to all batteries of the battery system.

S3031, sorting all of the second battery rebound parameters in ascending order, to obtain a fourth sequence; acquiring a second battery rebound parameter at a third target position in the fourth sequence as a fourth battery rebound parameter of the battery system, and acquiring a second battery rebound parameter at a fourth target position in the fourth sequence as a fifth battery rebound parameter of the battery system.

In some embodiments, the third target position may be the 75th position, and the fourth target position may be the 25th position. For example, second battery rebound parameters corresponding to all batteries may be sorted in ascending order, and a fourth battery rebound parameter $V4^{\wedge}$ at the 75th position and a fifth battery rebound parameter $V5^{\wedge}$ at the 25th position may be taken.

S3032, determining the rebound parameter threshold based on a difference between the fourth battery rebound parameter and the fifth battery rebound parameter.

In some embodiments, the rebound parameter threshold $V0^{\wedge}$ may be calculated based on the following formula:

$$V0^{\wedge}=V4^{\wedge}+1.5(V4^{\wedge}-V5^{\wedge}).$$

S304, when a third battery rebound parameter of any of the batteries is greater than the rebound parameter threshold, issuing a voltage rebound abnormality warning for the battery system.

As shown in FIG. 2, which is a schematic structural diagram of a battery thermal runaway risk diagnosis apparatus according to some embodiments of the present disclosure, the battery thermal runaway risk diagnosis apparatus according to some embodiments of the present disclosure includes:

an acquisition module, configured to, at each of first acquisition time points in a target cycle, acquire a first voltage of each cell of a battery; a first acquisition time point being an acquisition time point determined based on a first acquisition interval within a preset acquisition period, and the target cycle including a charging cycle, a discharging cycle, and a resting cycle;

a calculation module, configured to: calculate an average of first voltages of all cells at each of the first acquisition time points to obtain a voltage average; determine a respective first difference between the first voltage of each cell at each of the first acquisition time points and the voltage average; calculate an average of all first differences corresponding to all of the first acquisition time points for each cell to obtain a difference average;

where the difference average corresponding to the charging cycle is a first average, the difference average corresponding to the discharging cycle is a second average, the difference average corresponding to the resting cycle is a third average;

a judgment module, configured to, if the first average of the cell is greater than the third average and the second average is less than the third average, take the cell as a risk cell, and determine that a phenomenon of high voltage during charging and low voltage during discharging occurs to the battery.

Further, the calculation module may be further configured to: calculate a respective difference between the first average and the second average corresponding to each risk cell, to obtain a risk voltage difference; take each risk voltage difference as a severity parameter corresponding to the risk cell as a severity parameter of the risk cell; where the severity parameter is used to characterize a probability of the phenomenon of high voltage during charging and low voltage during discharging occurring to the risk cell;

the battery thermal runaway risk diagnosis apparatus may further include a warning module, configured to, if the severity parameter is greater than a preset threshold, issue an abnormality warning for high voltage during charging and low voltage during discharging of the battery.

Further, the calculation module is further configured to:

select a maximum value from severity parameters of all risk cells as a battery severity parameter corresponding to the acquisition period for the battery.

Further, the calculation module is further configured to:

in each of acquisition sub-periods within a preset total acquisition period, determine a respective first battery severity parameter corresponding to each battery in a battery system;

sort respective first battery severity parameters in all of the acquisition sub-periods for each battery in ascending order, to obtain a first sequence; acquire a first battery severity parameter at a first target position in the first sequence as a second battery severity parameter of the battery; acquire a first battery severity parameter at a second target position in the first sequence as a third battery severity parameter of the battery;

determine a parameter threshold based on respective second battery severity parameters corresponding to all batteries of the battery system;

when a third battery severity parameter of any of the batteries is greater than the parameter threshold, issue an abnormality warning for high voltage during charging and low voltage during discharging of the battery system.

Further, the apparatus further includes a voltage rebound detection module, configured to:

determine a target period within the resting cycle;

at each of second acquisition time points within the target period, acquire a second voltage of each cell of the battery; where a second acquisition time point is an acquisition time point determined based on a second acquisition interval within the target period; acquire a resting start voltage of each cell in the resting cycle;

at each of the second acquisition time points, calculate a respective difference between the second voltage of each cell and a corresponding resting start voltage, to obtain a rebound voltage;

calculate a respective average of rebound voltages at all of the second acquisition time points for each cell as an average rebound voltage; and based on the average rebound voltage of each cell, determine a respective rebound voltage threshold corresponding to the cell;

when any of the rebound voltages corresponding to the cell is greater than a corresponding rebound voltage threshold, take the cell as a rebound cell and issue a voltage rebound warning for the battery.

Further, the voltage rebound detection module is further configured to:

calculate a discharge rate and discharge capacity of the discharging cycle within last 3 minutes before a transition of the battery from the discharging cycle to the resting cycle;

when the discharge rate is greater than a first threshold and the discharge capacity is greater than a second threshold, take a 20th minute after a start of the resting cycle as a start time point and an end time of the resting cycle as an end time point, and determine the target period based on the start time point and the end time point.

Further, the voltage rebound detection module is further configured to:

for each cell, calculate a respective difference between each corresponding rebound voltage and a corresponding average rebound voltage, to obtain a voltage rebound parameter, and take a maximum value of all voltage rebound parameters of the cell as a cell rebound parameter of the cell;

take a maximum value of all cell rebound parameters as a battery rebound parameter of the battery.

Further, the voltage rebound detection module is further configured to:

in each of target sub-periods within a preset total target period, determine a respective first battery rebound parameter corresponding to each battery of the battery system;

sort respective first battery rebound parameters in all of the target sub-periods for each battery in ascending order, to obtain a third sequence; acquire a first battery rebound parameter at a first target position in the third sequence as a second battery rebound parameter of the battery; acquire a first battery rebound parameter at a second target position in the third sequence as a third battery rebound parameter of the battery;

determine a rebound parameter threshold based on respective second battery rebound parameters corresponding to all batteries of the battery system;

when a third battery rebound parameter of any of the batteries is greater than the rebound parameter threshold, issue a voltage rebound abnormality warning for the battery system.

Based on the same inventive concept as the aforementioned battery thermal runaway risk diagnosis method, an embodiment of the present disclosure further provides an electronic device, including a memory, a processor, and a computer program stored on the memory and executable on the processor, where when the processor executes the computer program, any step of the aforementioned battery thermal runaway risk diagnosis method is implemented.

Here, a bus architecture (represented by a bus), a bus may include any number of interconnected buses and bridges, and the bus connects various circuits including one or more processors represented by the processor and a memory represented by the memory. The bus may further connect various other circuits such as peripherals, voltage regulators, and power management circuits, which are well known in the art, and therefore will not be further described here. A bus interface provides an interface between the bus and a receiver and transmitter. The receiver and transmitter may be one and the same element, i.e., a transceiver, providing a unit for communicating with various other apparatuses on a transmission medium. The processor is responsible for managing the bus and general processing, and the memory may be used to store data used by the processor when performing operations.

Since the electronic device introduced in the embodiment of the present disclosure is an electronic device used to implement the battery thermal runaway risk diagnosis method in embodiments of the present disclosure, based on the battery thermal runaway risk diagnosis method introduced in the embodiments of the present disclosure, those skilled in the art can understand the specific implementation of the electronic device in the embodiment of the present disclosure and its various variations. Therefore, the specific implementation of the electronic device to achieve the method in the embodiments of the present disclosure will not be described in detail here. Any electronic device used by those skilled in the art to implement the battery thermal runaway risk diagnosis method in the embodiments of the present disclosure falls within the protection scope of the present disclosure.

Based on the same inventive concept as the aforementioned battery thermal runaway risk diagnosis method, the present disclosure further provides a computer-readable storage medium, where the computer-readable storage medium stores a computer program, and when the computer program is executed by a processor, any of the aforementioned battery thermal runaway risk diagnosis methods is implemented.

Those skilled in the art will understand that the embodiments of the present disclosure may be provided as methods, systems, or computer program products. Therefore, the present disclosure may take the form of a complete hardware embodiment, a complete software embodiment, or an embodiment combining software and hardware. Moreover, the present disclosure may take the form of a computer program product implemented on one or more computer-usable storage media (including but not limited to disk storage, CD-ROM, optical storage, etc.) containing computer-usable program codes.

The present disclosure is described with reference to the flowcharts and/or block diagrams of the methods, devices (systems), and computer program products according to the embodiments of the present disclosure. It should be understood that each process and/or block in the flowcharts and/or block diagrams, and the combination of processes and/or blocks in the flowcharts and/or block diagrams may be implemented by computer program instructions. These computer program instructions may be provided to a general-purpose computer, a special-purpose computer, an embedded processor, or the processor of other programmable data processing devices to produce a machine, so that the instructions executed by the computer or the processor of other programmable data processing devices produce apparatuses for implementing the functions specified in one or more processes in the flowcharts and/or one or more blocks in the block diagrams.

These computer program instructions may also be stored in a computer-readable memory that can guide a computer or other programmable data processing devices to work in a specific manner, so that the instructions stored in the computer-readable memory produce a manufactured product including an instruction apparatus, and the instruction apparatus implements the functions specified in one or more processes in the flowcharts and/or one or more blocks in the block diagrams.

These computer program instructions may also be loaded onto a computer or other programmable data processing devices, so that a series of operation steps are performed on the computer or other programmable devices to produce computer-implemented processing, and the instructions executed on the computer or other programmable devices provide steps for implementing the functions specified in one or more processes in the flowcharts and/or one or more blocks in the block diagrams.

Although the preferred embodiments of the present disclosure have been described, those skilled in the art can make additional changes and modifications to these embodiments once they understand the basic creative concept. Therefore, the appended claims are intended to be interpreted as including the preferred embodiments and all changes and modifications falling within the scope of the present disclosure.

It is obvious that those skilled in the art can make various changes and variations to the present disclosure without departing from the spirit and scope of the present disclosure. Therefore, if these changes and variations of the present disclosure fall within the scope of the claims of the present disclosure and their equivalent technologies, the present disclosure is also intended to include these changes and variations.

## Claims

1. A battery thermal runaway risk diagnosis method, comprising:

   at each of first acquisition time points in a target cycle, acquiring a first voltage of each cell of a battery; wherein the target cycle comprises a charging cycle, a discharging cycle, and a resting cycle;
   calculating an average of first voltages of all cells at each of the first acquisition time points to obtain a voltage average;
   determining a respective first difference between the first voltage of each cell at each of the first acquisition time points and the voltage average;
   calculating an average of all first differences corresponding to all of the first acquisition time points for each cell to obtain a difference average, wherein the difference average corresponding to the charging cycle is a first average, the difference average corresponding to the discharging cycle is a second average, the difference average corresponding to the resting cycle is a third average; and

if the first average of the cell is greater than the third average, and the second average is less than the third average, determining that a phenomenon of high voltage during charging and low voltage during discharging occurs to the battery.

2. The battery thermal runaway risk diagnosis method according to claim 1, wherein after the determining that a phenomenon of high voltage during charging and low voltage during discharging occurs to the battery, the method further comprises:

if the first average of the cell is greater than the third average, and the second average is less than the third average, taking the cell as a risk cell;

calculating a respective difference between the first average and the second average corresponding to each risk cell, to obtain a risk voltage difference;

taking each risk voltage difference as a severity parameter corresponding to the risk cell; wherein the severity parameter is used to characterize a probability of the phenomenon of high voltage during charging and low voltage during discharging occurring to the risk cell;

if the severity parameter is greater than a preset threshold, issuing an abnormality warning for high voltage during charging and low voltage during discharging of the battery.

3. The battery thermal runaway risk diagnosis method according to claim 2, wherein the first acquisition time points are acquisition time points determined based on a first acquisition interval within a preset acquisition period,

after the issuing the abnormality warning for high voltage during charging and low voltage during discharging of the battery, the method further comprises:

selecting a maximum value from severity parameters of all risk cells as a battery severity parameter corresponding to the acquisition period for the battery.

4. The battery thermal runaway risk diagnosis method according to claim 3, wherein after the selecting a maximum value from severity parameters of all risk cells as a battery severity parameter corresponding to the acquisition period for the battery, the method further comprises:

in each of acquisition sub-periods within a preset total acquisition period, determining a respective first battery severity parameter corresponding to each battery in a battery system;

sorting respective first battery severity parameters in all of the acquisition sub-periods for each battery in ascending order, to obtain a first sequence; acquiring a first battery severity parameter at a first target position in the first sequence as a second battery severity parameter of the battery; acquiring a first battery severity parameter at a second target position in the first sequence as a third battery severity parameter of the battery;

determining a parameter threshold based on respective second battery severity parameters corresponding to all batteries of the battery system;

when a third battery severity parameter of any of the batteries is greater than the parameter threshold, issuing an abnormality warning for high voltage during charging and low voltage during discharging of the battery system.

5. The battery thermal runaway risk diagnosis method according to claim 4, wherein the determining a parameter threshold based on respective second battery severity parameters corresponding to all batteries of the battery system comprises:

sorting all of the second battery severity parameters in ascending order, to obtain a second sequence; acquiring a second battery severity parameter at a third target position in the second sequence as a fourth battery severity parameter of the battery system, and acquiring a second battery severity parameter at a fourth target position in the second sequence as a fifth battery severity parameter of the battery system;

determining the parameter threshold based on a difference between the fourth battery severity parameter and the fifth battery severity parameter.

6. The battery thermal runaway risk diagnosis method according to claim 1, wherein the method further comprises:

determining a target period within the resting cycle;

at each of second acquisition time points within the target period, acquiring a second voltage of each cell of the battery; wherein the second acquisition time points are acquisition time points determined based on a second acquisition interval within the target period;

acquiring a resting start voltage of each cell in the resting cycle;

at each of the second acquisition time points, calculating a respective difference between the second voltage of each cell and a corresponding resting start voltage, to obtain a rebound voltage;

calculating a respective average of rebound voltages at all of the second acquisition time points for each cell as an average rebound voltage; and based on the average rebound voltage of each cell, determining a respective rebound voltage threshold corresponding to the cell;

when any of the rebound voltages corresponding to the cell is greater than a corresponding rebound voltage threshold, taking the cell as a rebound cell and issuing a voltage rebound warning for the battery.

7. The battery thermal runaway risk diagnosis method according to claim 6, wherein the determining a target period within the resting cycle comprises:

calculating a discharge rate and discharge capacity of the discharging cycle within last 3 minutes before a transition of the battery from the discharging cycle to the resting cycle;

when the discharge rate is greater than a first threshold and the discharge capacity is greater than a second threshold, taking a 20th minute after a start of the resting cycle as a start time point and an end time of the resting cycle as an end time point, and determining the target period based on the start time point and the end time point.

8. The battery thermal runaway risk diagnosis method according to claim 6, wherein after the issuing a voltage rebound warning for the battery, the method comprises:

for each cell, calculating a respective difference between each corresponding rebound voltage and a corresponding average rebound voltage, to obtain a voltage rebound parameter, and taking a maximum value of all voltage rebound parameters of the cell as a cell rebound parameter of the cell;

taking a maximum value of all cell rebound parameters as a battery rebound parameter of the battery.

9. The battery thermal runaway risk diagnosis method according to claim 8, wherein the method further comprises:

in each of target sub-periods within a preset total target period, determining a respective first battery rebound parameter corresponding to each battery of the battery system;

sorting respective first battery rebound parameters in all of the target sub-periods for each battery in ascending order, to obtain a third sequence; acquiring a first battery rebound parameter at a first target position in the third sequence as a second battery rebound parameter of the battery; acquiring a first battery rebound parameter at a second target position in the third sequence as a third battery rebound parameter of the battery;

determining a rebound parameter threshold based on respective second battery rebound parameters corresponding to all batteries of the battery system;

when a third battery rebound parameter of any of the batteries is greater than the rebound parameter threshold, issuing a voltage rebound abnormality warning for the battery system.

10. The battery thermal runaway risk diagnosis method according to claim 9, wherein the determining a rebound parameter threshold based on respective second battery rebound parameters corresponding to all batteries of the battery system comprises:

sorting all of the second battery rebound parameters in ascending order, to obtain a fourth sequence; acquiring a second battery rebound parameter at a third target position in the fourth sequence as a fourth battery rebound parameter of the battery system, and acquiring a second battery rebound parameter at a fourth target position in the fourth sequence as a fifth battery rebound parameter of the battery system;

determining the rebound parameter threshold based on a difference between the fourth battery rebound parameter and the fifth battery rebound parameter.

11. A battery thermal runaway risk diagnosis apparatus, comprising:

an acquisition module, configured to, at each of first acquisition time points in a target cycle, acquire a first voltage of each cell of a battery; wherein the target cycle comprises a charging cycle, a discharging cycle, and a resting cycle;

a calculation module, configured to: calculate an average of first voltages of all cells at each of the first acquisition time points to obtain a voltage average; determine a respective first difference between the first voltage of each cell at each of the first acquisition time points and the voltage average; calculate an average of all first differences corresponding to all of the first acquisition time points for each cell to obtain a difference average;

wherein the difference average corresponding to the charging cycle is a first average, the difference average corresponding to the discharging cycle is a second average, the difference average corresponding to the resting cycle is a third average; and

a judgment module, configured to, if the first average of the cell is greater than the third average and the second average is less than the third average, determine that a phenomenon of high voltage during charging and low voltage during discharging occurs to the battery.

12. The battery thermal runaway risk diagnosis apparatus according to claim 11, wherein after the determining that a phenomenon of high voltage during charging and low voltage during discharging occurs to the battery, the calculation module is further configured to:

if the first average of the cell is greater than the third average, and the second average is less than the third average, take the cell as a risk cell; calculate a respective difference between the first average and the second average corresponding to each risk cell, to obtain a risk voltage difference;

take each risk voltage difference as a severity parameter corresponding to the risk cell as a severity parameter of the risk cell; wherein the severity parameter is used to characterize a probability of the phenomenon of high voltage during charging and low voltage during discharging occurring to the risk cell;

the battery thermal runaway risk diagnosis apparatus further comprises a warning module, configured to, if the severity parameter is greater than a preset threshold, issue an abnormality warning for high voltage during charging and low voltage during discharging of the battery.

13. The battery thermal runaway risk diagnosis apparatus according to claim 12, wherein the calculation module is further configured to:
select a maximum value from severity parameters of all risk cells as a battery severity parameter corresponding to the acquisition period for the battery.

14. The battery thermal runaway risk diagnosis apparatus according to claim 13, wherein the calculation module is further configured to:

in each of acquisition sub-periods within a preset total acquisition period, determine a respective first battery severity parameters corresponding to each battery in a battery system; sort respective first battery severity parameters in all of the acquisition sub-periods for each battery in ascending order, to obtain a first sequence; acquire a first battery severity parameter at a first target position in the first sequence as a second battery severity parameter of the battery; acquire a first battery severity parameter at a second target position in the first sequence as a third battery severity parameter of the battery;

determine a parameter threshold based on respective second battery severity parameters corresponding to all batteries of the battery system;

when a third battery severity parameter of any of the batteries is greater than the parameter threshold, issue an abnormality warning for high voltage during charging and low voltage during discharging of the battery system.

15. The battery thermal runaway risk diagnosis apparatus according to claim 11, wherein the apparatus further comprises a voltage rebound detection module, configured to:

determine a target period within the resting cycle;

at each of second acquisition time points within the target period, acquire a second voltage of each cell of the battery; wherein the second acquisition time points are acquisition time points determined based on a second acquisition interval within the target period; acquire a resting start voltage of each cell in the resting cycle;

at each of the second acquisition time points, calculate a respective difference between the second voltage of each of the cells and the corresponding resting start voltage, to obtain a rebound voltage;

calculate a respective average of rebound voltages at all of the second acquisition time points for each cell as an average rebound voltage; and based on the average rebound voltage of each cell, determine a respective rebound voltage threshold corresponding to the cell;

when any of the rebound voltages corresponding to the cell is greater than a corresponding rebound voltage threshold, take the cell as a rebound cell and issue a voltage rebound warning for the battery.

16. The battery thermal runaway risk diagnosis apparatus according to claim 15, wherein the voltage rebound detection module is further configured to:

calculate a discharge rate and discharge capacity of the discharging cycle within last 3 minutes before a transition of the battery from the discharging cycle to the resting cycle; when the discharge rate is greater than a first threshold and the discharge capacity is greater than a second threshold, take a 20th minute after a start of the resting cycle as a start time point and an end time of the resting cycle as an end time point, and determine the target period based on the start time point and the end time point.

17. The battery thermal runaway risk diagnosis apparatus according to claim 15, wherein the voltage rebound detection module is further configured to:

for each cell, calculate a respective difference between each corresponding rebound voltage and a corresponding average rebound voltage, to obtain a voltage rebound parameter, and take a maximum value of all voltage rebound parameters of the cell as a cell rebound parameter of the cell;

take a maximum value of all cell rebound parameters as a battery rebound parameter of the battery.

18. The battery thermal runaway risk diagnosis apparatus according to claim 17, wherein the voltage rebound detection module is further configured to:

in each of target sub-periods within a preset total target period, determine a respective first battery rebound parameters corresponding to each battery of the battery system;

sort respective first battery rebound parameters in all of the target sub-periods for each battery in ascending order, to obtain a third sequence; acquire a first battery rebound parameter at a first target position in the third sequence as a second battery rebound parameter of the battery; acquire a first battery rebound parameter at a second target position in the third sequence as a third battery rebound parameter of the battery; determine a rebound parameter threshold based on respective second battery rebound parameters corresponding to all batteries of the battery system;

when a third battery rebound parameter of any of the batteries is greater than the rebound parameter threshold, issue a voltage rebound abnormality warning for the battery system.

19. An electronic device, comprising a memory, a processor, and a computer program stored on the memory and executable on the processor, wherein when the processor executes the computer program, the battery thermal runaway risk diagnosis method according to any one of claims 1 to 10 is implemented.

20. A computer-readable storage medium, wherein the computer-readable storage medium stores a computer program, and when the computer program is executed by a processor, the battery thermal runaway risk diagnosis method according to any one of claims 1 to 10 is implemented.

| At each of first acquisition time points in a target cycle, acquiring a first voltage of each cell of a battery | S1 |

| Calculating an average of first voltages of all cells at each of the first acquisition time points to obtain a voltage average; determining a respective first difference between the first voltage of each cell at each of the first acquisition time points and the voltage average; calculating an average of all first differences corresponding to all of the first acquisition time points for each cell to obtain a difference average | S2 |

| If the first average of the cell is greater than the third average, and the second average is less than the third average, determining that a phenomenon of high voltage during charging and low voltage during discharging occurs to the battery | S3 |

FIG. 1

Battery thermal runaway risk diagnosis apparatus

Acquisition module

Calculation module

Judgment module

FIG. 2

## INTERNATIONAL SEARCH REPORT

| International application No. |
|---|
| **PCT/CN2024/140668** |

| A. | CLASSIFICATION OF SUBJECT MATTER |
|---|---|

G01R31/392(2019.01)i; G01R31/396(2019.01)i; G01R31/36(2020.01)i; G01R31/367(2019.01)i

According to International Patent Classification (IPC) or to both national classification and IPC

| B. | FIELDS SEARCHED |
|---|---|

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNTXT, ENTXTC, CNKI, ENTXT, VEN: 电池, 电芯, 热失控, 充高放低, 电压, 平均, 均值, 差, 充电, 放电, 静置, 阈值, 回弹电压, battery, electric core, thermal runaway, charged high, discharged low, voltage, average, difference, charge, discharge, rest, threshold, limit, rebound voltage

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 117783917 A (VOYAH AUTOMOBILE TECHNOLOGY CO., LTD.) 29 March 2024 (2024-03-29)<br>claims 1-10, and description, paragraphs 0003-0108 | 1-5, 11-14, 19-20 |
| Y | US 2022352737 A1 (GM GLOBAL TECHNOLOGY OPERATIONS LLC) 03 November 2022 (2022-11-03)<br>description, paragraphs 0003-0045 | 1-20 |
| Y | CN 115805810 A (CONTEMPORARY AMPEREX TECHNOLOGY CO., LTD.) 17 March 2023 (2023-03-17)<br>description, paragraphs 0076-0192 | 1-20 |
| Y | CN 117630692 A (CAMEL GROUP WUHAN OPTICS VALLEY R&D CENTER CO., LTD.) 01 March 2024 (2024-03-01)<br>description, paragraphs 0009-0037 | 6-10, 15-18 |
| A | CN 106932722 A (HUAWEI TECHNOLOGIES CO., LTD.) 07 July 2017 (2017-07-07)<br>entire document | 1-20 |

| ☑ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **29 March 2025** | **05 April 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2024/140668** |

**C.    DOCUMENTS CONSIDERED TO BE RELEVANT**

| Category* | Citation of document, with indication, where appropriate, of the relevant passages | Relevant to claim No. |
|---|---|---|
| A | CN 111913113 A (SVOLT ENERGY TECHNOLOGY CO., LTD.) 10 November 2020 (2020-11-10)<br>entire document | 1-20 |
| A | CN 113075575 A (HUNAN UNIVERSITY) 06 July 2021 (2021-07-06)<br>entire document | 1-20 |
| A | CN 113442787 A (SHANGHAI KLCLEAR NEW ENERGY TECHNOLOGY CO., LTD.) 28 September 2021 (2021-09-28)<br>entire document | 1-20 |
| A | CN 114660472 A (GREAT WALL MOTOR CO., LTD.) 24 June 2022 (2022-06-24)<br>entire document | 1-20 |
| A | CN 115656834 A (WUHAN POWER BATTERY REGENERATION TECHNOLOGY CO., LTD. et al.) 31 January 2023 (2023-01-31)<br>entire document | 1-20 |
| A | CN 117103997 A (HARBIN INSTITUTE OF TECHNOLOGY, WEIHAI et al.) 24 November 2023 (2023-11-24)<br>entire document | 1-20 |

Form PCT/ISA/210 (second sheet) (July 2022)

## INTERNATIONAL SEARCH REPORT
### Information on patent family members

International application No.

**PCT/CN2024/140668**

| Patent document cited in search report | | | Publication date (day/month/year) | Patent family member(s) | | | Publication date (day/month/year) |
|---|---|---|---|---|---|---|---|
| CN | 117783917 | A | 29 March 2024 | None | | | |
| US | 2022352737 | A1 | 03 November 2022 | DE | 102022105477 | A1 | 03 November 2022 |
| CN | 115805810 | A | 17 March 2023 | None | | | |
| CN | 117630692 | A | 01 March 2024 | None | | | |
| CN | 106932722 | A | 07 July 2017 | WO | 2017114195 | A1 | 06 July 2017 |
| CN | 111913113 | A | 10 November 2020 | None | | | |
| CN | 113075575 | A | 06 July 2021 | None | | | |
| CN | 113442787 | A | 28 September 2021 | None | | | |
| CN | 114660472 | A | 24 June 2022 | None | | | |
| CN | 115656834 | A | 31 January 2023 | None | | | |
| CN | 117103997 | A | 24 November 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311827281